# EUROPÄISCHE PATENTSCHRIFT

(11) **EP 1 134 589 B1**
(45) Veröffentlichungstag und Bekanntmachung des Hinweises auf die Patenterteilung: **23.03.2005**
(21) Anmeldenummer: 00127201.2
(22) Anmeldetag: 14.12.2000
(51) Int. Cl.: G01R 31/00

(54) **Verfahren zur Detektion einer fehlerhaften Masseverbindung in einer elektrischen Einrichtung insbesondere eines Kraftfahrzeugs**
Method for detecting a faulty earth connection e.g. in a vehicle
Méthode de détection d'une connection fautive de masse dans un circuit électrique, en particulier d'un véhicule

(30) Priorität: 21.01.2000 DE 10002537
(43) Veröffentlichungstag der Anmeldung: 19.09.2001
(73) Patentinhaber: Volkswagen Aktiengesellschaft, 38436 Wolfsburg (DE)
(72) Erfinder: Altenkirch, Manfred, Dipl.Ing, 38553 Wasbüttel (DE)

(56) Entgegenhaltungen:
- EP-A- 0 519 156
- DE-A- 19 611 522
- US-A- 4 347 540
- US-A- 4 725 912
- US-A- 5 933 077
- PATENT ABSTRACTS OF JAPAN vol. 013, no. 570 (P-977), 18. Dezember 1989 (1989-12-18) & JP 01 237894 A (HITACHI MAXELL LTD), 22. September 1989 (1989-09-22)

## Beschreibung

Die Erfindung betrifft ein Verfahren zur Detektion einer fehlerhaften Masseverbindung in einer elektrischen Einrichtung insbesondere eines Kraftfahrzeugs, entsprechend dem Oberbegriff des Anspruchs 1.

Verfahren zur Detektion von fehlerhaften Masseverbindungen -im Folgenden auch Detektionsverfahren genannt- sind bekannt. Sie überwachen das ordnungsgemäße Funktionieren von Masseverbindungen in einer elektrischen Einrichtung beispielsweise von Kraftfahrzeugen und lösen bei Feststellen einer fehlerhaften Masseverbindung defektbehebende Maßnahmen aus. Hierzu werden die verschiedenen elektrischen Teilsysteme zum Beispiel eines Kraftfahrzeugs, wie das Motorsteuergerät, die Lichtanlage oder die Scheibenhebevorrichtung, an das als Batteriepol dienende Chassis des Kraftfahrzeugs angeschlossen.

In der deutschen Offenlegungsschrift DE 197 23 456 wird eine Vorrichtung der eingangs genannten Art beschrieben, die zur Überwachung von Masseverbindungen von Teilsystemen dient, die über jeweils zwei Schaltelemente an die Vorrichtung angeschlossen sind. Die Schaltelemente weisen hierbei jeweils zwei Schaltstellungen auf. Die Vorrichtung ist so ausgelegt, dass die Detektion einer fehlerhaften Masseverbindung nur dann erfolgen kann, wenn sich die beiden Schaltelemente jeweils in einer bestimmten Schaltstellung befinden, während dies bei den anderen Schaltstellungskombinationen nur eingeschränkt oder überhaupt nicht möglich ist. Die Detektion einer fehlerhaften Masseverbindung ist mithin nicht immer in zuverlässiger Weise durchführbar.

Ferner offenbart die US-A-5,933,077 ein Alarmsystem, auf welchem der Oberbegriff des Anspruchs 1 basiert. Das Alarmsystem enthält eine Steuerung, mehrere Transponder und wenigstens einen mit einem der Transponder verbundenen Wandler, und detektiert eine fehlerhafte Masseverbindung durch Vergleichen eines in einer speziellen Schaltung gemessenen Spannungswerts mit einem Referenzwert.

Außerdem beschreibt die EP 0 519 156 A1 eine Schutzschaltung für MOS-Bauelemente, die eine Überbrückungsschaltung mit einem Diodenelement zwischen zwei Masseverbindungen aufweist, um die beiden Masseverbindungen parallel zu schalten.

Aufgabe der Erfindung ist es, ein gattungsgemäßes Verfahren zur Detektion von fehlerhaften Masseverbindungen zu entwickeln, das bei Feststellen einer fehlerhaften Masseverbindung einem Ausfall einer elektrischen Einrichtung vorbeugt.

Diese Aufgabe wird gelöst durch Verfahren zur Detektion einer fehlerhaften Masseverbindung in einer elektrischen Einrichtung, insbesondere eines Kraftfahrzeugs, die über wenigstens zwei Masseverbindungen mit einer Masse verbunden ist, mit den Verfahrensschritten:
- Ermitteln eines Messwerts eines Detektionsparameters mittels einer mit den wenigstens zwei Masseverbindungen verbundenen Detektionsschaltung;
- Vergleichen des ermittelten Messwerts mit einem festlegbaren Referenzwert;
- Feststellen wenigstens einer fehlerhaften Masseverbindung bei einer Abweichung zwischen dem Messwert und dem Referenzwert;
- Erzeugen einer Fehlermeldung bei festgestellter fehlerhafter Masseverbindung,
wobei, bei einer Fehlermeldung, eine fehlerhafte Masseverbindung und eine fehlerfreie Masseverbindung durch eine Überbrückungsschaltung, die zwischen der fehlerhaften Masseverbindung und der fehlerfreien Masseverbindung zum wahlweisen elektrischen Verbinden der Masseverbindungen vorgesehen ist und die bei Nicht-Vorliegen einer Fehlermeldung geöffnetes Schaltmittel enthält, durch Schließen des Schaltmittels der Überbrückungsschaltung parallel geschaltet werden.

Die Erfindung macht sich die Erkenntnis zunutze, dass sich die Fehlerhaftigkeit einer Masseverbindung nicht immer durch ein vollständiges Lösen der Masseverbindung äußert, sondern dass durch deren Lösen oder Korrosion Übergangswiderstände entstehen, die einen Spannungsabfall an der Masseverbindung nach sich ziehen. Diese Spannungsabfälle werden mittels des zweischrittigen erfindungsgemäßen Verfahrens detektiert. In dem ersten Verfahrensschritt wird, beispielsweise im Produktionswerk des Kraftfahrzeugs nach dem Einbau der elektrischen Einrichtung oder bei dessen Endkontrolle, ein Referenzwert eines Detektionsparameters ermittelt, der ausschließlich fehlerfreien Masseverbindungen entspricht. Dieser Referenzwert wird in der elektrischen Einrichtung des Kraftfahrzeugs abgespeichert. Ist das Kraftfahrzeug nach Verlassen des Produktionswerks in Fahrbetrieb, so wird in dem zweiten Verfahrensschritt ein den jeweiligen Fahrbetrieb kennzeichnender Messwert ermittelt. Stimmt der Messwert mit dem gespeicherten Referenzwert überein, so liegen fehlerfreie Masseverbindungen vor. Bei einer Abweichung zwischen dem Messwert und dem Referenzwert, wird auf die Tatsache geschlossen, dass eine oder mehrere der gemessenen Masseverbindungen fehlerhaft ist beziehungsweise sind. Aus der Art der Abweichung des Messwerts von dem Referenzwert ist für eine entsprechende Detektionsvorrichtung ferner ersichtlich, welche der Masseverbindungen fehlerhaft ist beziehungsweise sind. Als Reaktion hierauf erfolgt eine Fehlermeldung. Da nach Übermittlung einer Fehlermeldung eine fehlerfreie Masseverbindung mittels einer mit den Masseverbindungen verbundenen Überbrückungsschaltung zugeschaltet wird, besteht die Möglichkeit, eine fehlerfreie Masseverbindung parallel zur fehlerhaften Masseverbindung zuzuschalten beziehungsweise die fehlerhafte Masseverbindung zu unterbrechen und somit ausschließlich auf die fehlerfreie Masseverbindung umzuschalten. Dies hat den Vorteil, dass während des Betriebs des entsprechenden Kraftfahrzeugs das Teilsystem, dessen Masseverbindung fehlerhaft ist, wieder vollständig mit Masse verbunden wird. Einem Ausfall des entsprechenden Teilsystems, der aufgrund der Vernetzung der Teilsysteme untereinander mitunter einen Ausfall der kompletten elektrischen Einrichtung des Kraftfahrzeugs nach sich ziehen kann, wird dadurch vorgebeugt.

Bevorzugt wird ferner, dass bei einer Fehlermeldung über eine mit den Masseverbindungen verbundenen Meldeschaltung ein Fehlersignal ausgegeben wird. Das Signal kann beispielsweise derart übermittelt werden, dass es für den Fahrer des Kraftfahrzeugs jederzeit wahrnehmbar beziehungsweise abrufbar ist. Dies hat den Vorteil, dass die Überbrückungsschaltung einen Ausfall des der defekten Masseverbindung zugeordneten Teilsystems verhindert und gleichzeitig dem Fahrer signalisiert wird, dass in der elektrischen Einrichtung Veränderungen eingeleitet worden sind und ein Aufsuchen einer Werkstatt ratsam ist.

In einer Weiterbildung der Erfindung ist vorgesehen, dass die Fehlermeldung mittels einer mit den Masseverbindungen verbundenen Meldeschaltung in einem Speichermittel der elektrischen Einrichtung hinterlegt wird. Dies hat den Vorteil, dass bei der nächsten routinemäßigen Inspektion des Kraftfahrzeugs in der Werkstatt dem Kraftfahrzeugtechniker, nachdem er sein Diagnosegerät an die elektrische Einrichtung des Kraftfahrzeugs angeschlossen hat, zur Kenntnis gebracht wird, dass in der elektrischen Einrichtung Veränderungen, in diesem Fall Ersetzungen fehlerhafter Masseverbindungen durch fehlerfreie Masseverbindungen, vor sich gingen. Da die Detektionsschaltung aus der Art der Abweichung des Messwerts von dem Referenzwert auch feststellen kann, welche der Masseverbindungen fehlerhaft ist und die Meldeschaltung diese Information auch an den Kraftfahrzeugtechniker weitergibt, ist es für diesen ohne weiteres möglich, die fehlerhafte überbrückte Masseverbindung zu lokalisieren, sie durch eine fehlerfreie Masseverbindung zu ersetzen und die hergestellte Überbrückung aufzuheben.

Bevorzugt wird ferner, dass die Detektionsschaltung mittels einer mit ihr verbundenen Kontrollschaltung punktuell zu vorgebbaren Zeitpunkten oder kontinuierlich in vorgebbaren Zeitintervallen oder permanent kontrolliert wird. Diese Weiterbildung hat den den Vorteil, dass in Abhängigkeit von der Häufigkeit der Beanspruchung des der jeweiligen Masseverbindung zugeordneten Teilsystems der elektrischen Einrichtung die Häufigkeit der Detektion variiert werden kann. Da der Betrieb des Kraftfahrzeugs immer auch mit dem Betrieb des Steuergeräts des Antriebsmotors, gleichzeitig jedoch nicht immer auch mit dem Betrieb beispielsweise der Lichtanlage einhergeht, ist das Motorsteuergerät öfter und länger in Betrieb, als dies bei der Lichtanlage der Fall ist. Beim Motorsteuergerät ist daher die Wahrscheinlichkeit einer Fehlerhaftigkeit der Masseverbindung größer als bei der Lichtanlage, eine öfter stattfindende und länger andauernde Detektion der zugehörigen Masseverbindung ist mithin sinnvoll und wird durch die Kontrollschaltung in vorteilhafter Weise möglich.

Überdies wird bevorzugt, dass der Detektionsparameter und der Parameter des Referenzwerts als elektrische Spannung herangezogen werden. Elektrische Spannungen können in besonders einfacher Weise an einem mit den Masseverbindungen elektrisch verbundenen Widerstandsnetzwerk abgegriffen werden. Sowohl zur Bestimmung des Referenzspannungswerts wie auch zur Ermittlung des Detektionspannungswerts bedient man sich vorteilhafterweise des gleichen Widerstandsnetzwerkes, was die Anzahl der eingesetzten Bauelemente verringert.

Bevorzugte Weiterbildungen und Ausführungsformen der Erfindung werden im Folgenden anhand einer schematischen Zeichnung erläutert. Es zeigen:
- Figur 1: eine erfindungsgemäße Detektionsvorrichtung und zwei Teilsysteme einer elektrischen Einrichtung eines Kraftfahrzeugs als Schaltbild;
- Figur 2: die Detektionsvorrichtung in schematischer Darstellung;
- Figur 3a, 3b, 3c: eine erfindungsgemäße Detektionsschaltung, die mit verschiedenen Kombinationen fehlerhafter Masseverbindungen verbunden ist, sowie
- Figur 4a, 4b: jeweils eine bevorzugte Ausführungsform einer erfindungsgemäßen Überbrückungsschaltung.

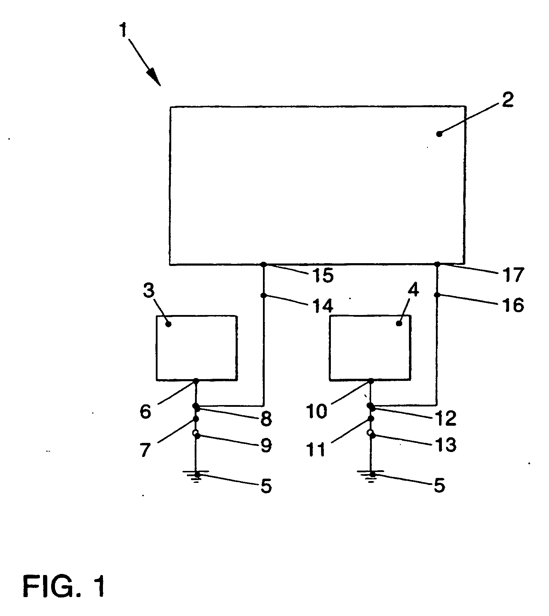

Figur 1 zeigt eine elektrische Einrichtung 1 eines Kraftfahrzeugs (nicht dargestellt). Die Einrichtung 1 weist eine Detektionsvorrichtung 2 sowie ein erstes Teilsystem 3 und ein zweites Teilsystem 4 auf. Das erste Teilsystem 3 und das zweite Teilsystem 4 sind sowohl mit der Detektionsvorrichtung 2 als auch mit einer Masse 5 elektrisch verbunden. An einem Punkt 6 verläßt hierfür eine elektrische Verbindung 7 das erste Teilsystem 3 und verläuft über einen Verzweigungspunkt 8 und eine Masseverbindung 9 zu einer Masse 5. Entsprechend verläßt an einem Punkt 10 eine elektrische Verbindung 11 das zweite Teilsystem 4 und verläuft über einen Verzweigungspunkt 12 und eine Masseverbindung 13 ebenfalls zu der Masse 5. Am Verzweigungspunkt 8 zweigt eine elektrische Verbindung 14 von der elektrischen Verbindung 7 ab und stellt an einem Punkt 15 die elektrische Verbindung zu der Detektionsvorrichtung 2 her. Entsprechend zweigt an dem Verzweigungspunkt 12 eine elektrische Verbindung 16 von der elektrischen Verbindung 11 ab und tritt an einem Punkt 17 ebenfalls mit der Detektionsvorrichtung 2 elektrisch in Verbindung.

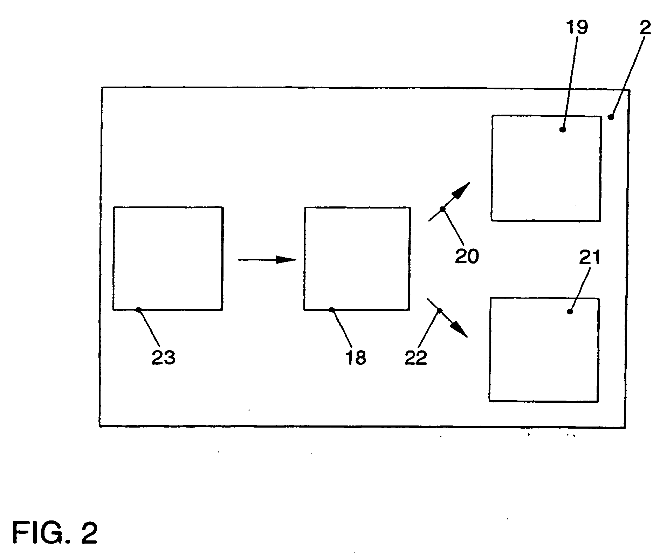

Figur 2 zeigt schematisch, aus welchen Teilschaltungen sich die Detektionsvorrichtung 2 zusammensetzt. Die wichtigste dieser Teilschaltungen ist eine Detektionsschaltung 18. Die Detektionsschaltung 18 spricht -sobald sie die Fehlerhaftigkeit einer Masseverbindung erkannt hat- eine Überbrückungsschaltung 19 an, was in Figur 2 durch einen Pfeil 20 symbolisch dargestellt ist. Die Detektionsschaltung 18 spricht im Falle einer fehlerhaften Masseverbindung des weiteren eine Meldeschaltung 21 an, die zum einen an den Fahrer des Kraftfahrzeugs eine diesbezügliche Meldung abgibt, zum anderen für den Kraftfahrzeugtechniker einer Werkstatt eine entsprechende Meldung in der elektrischen Einrichtung 1 des Kraftfahrzeugs speichertechnisch hinterlegt. Das Wirken der Detektionsschaltung 18 auf die Meldeschaltung 21 ist in Figur 2 durch einen Pfeil 22 verbildlicht. In welchen Zeitabständen und in welchen Zeitintervallen die Detektionsschaltung 18 die Masseverbindungen auf ihre Fehlerhaftigkeit hin überprüft, wird mittels einer Kontrollschaltung 23 kontrolliert.

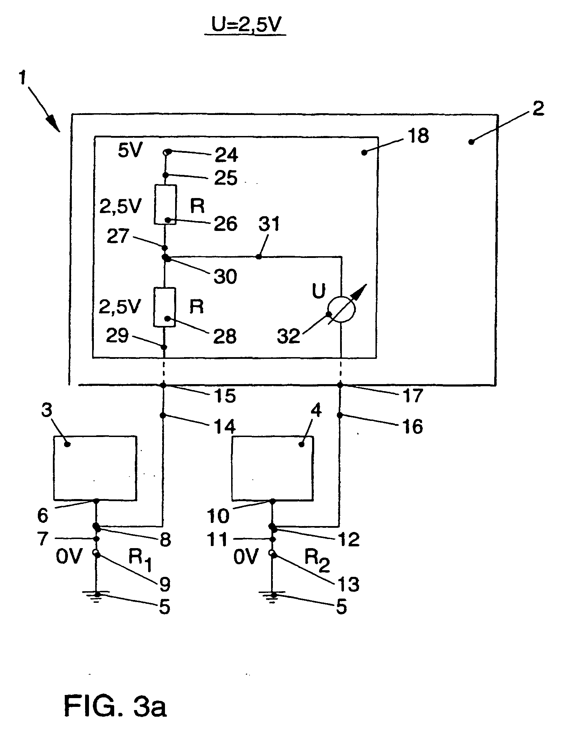

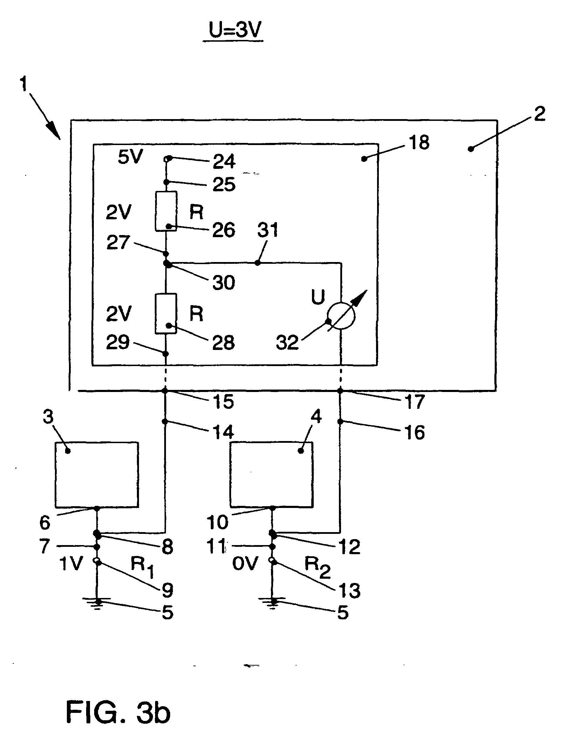

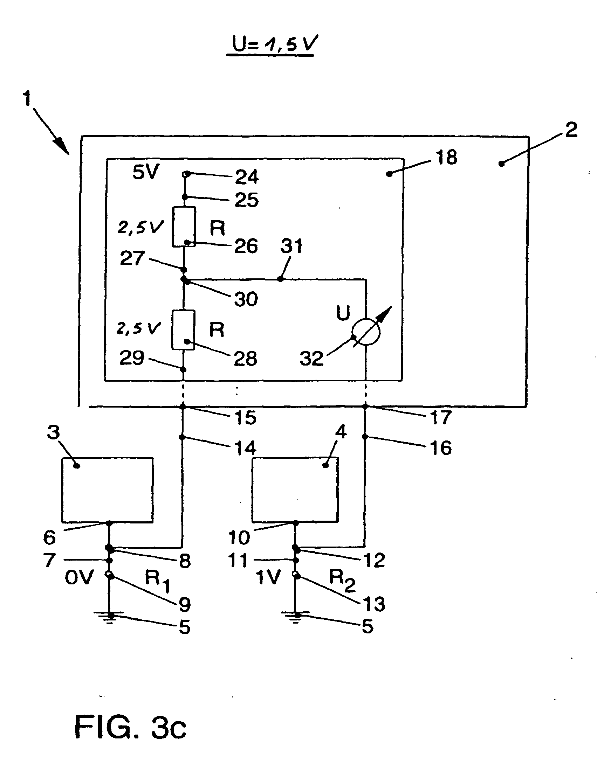

Die Figuren 3a, 3b und 3c zeigen eine bevorzugte Ausführungsform der Detektionsschaltung 18, die in die Detektionsvorrichtung 2 der elektrischen Einrichtung 1 des Kraftfahrzeugs eingebaut ist. Gleiche Bauteile sind mit den gleichen Bezugszeichen wie in Figur 1 und 2 versehen, so dass insofern auf die dortige Beschreibung verwiesen werden kann.

Figur 3a zeigt die Detektionsschaltung 18 sowie deren elektrische Kenngrößen für den Fall zweier fehlerfreier Masseverbindungen 9 und 13. Die Detektionsschaltung 18 weist eine Spannungsquelle 24 auf, durch die sie mit einer elektrischen Spannung von beispielsweise 5 Volt versorgt wird. Die Spannungsquelle 24 steht über eine elektrische Verbindung 25 mit einem Widerstand 26 in Verbindung. Über eine elektrische Verbindung 27 steht der Widerstand 26 mit einem weiteren Widerstand 28 in Verbindung. Eine elektrische Verbindung 29 stellt die Verbindung zu dem Punkt 15 her. Die elektrische Verbindung 27 weist einen Verzweigungspunkt 30 auf, der die elektrische Verbindung 27 über eine elektrische Verbindung 31 mit einem Spannungsmeßgerät 32 verbindet. Die Verbindung zwischen dem Spannungsmeßgerät 32 und dem Punkt 17 stellt schließlich eine elektrische Verbindung 33 her.

Figur 3a stellt schaltungstechnisch diejenige Situation dar, die für die Ermittlung der Referenzspannung, also für die Ermittlung derjenigen Spannung, die dem Fall fehlerfreier Masseverbindungen zugeordnet ist, notwendig ist. Die beiden Masseverbindungen 9 und 13 weisen also verschwindende Übergangswiderstände R₁ und R₂ auf, an denen daher jeweils eine Spannung von 0 Volt abfällt. Durch den in der Detektionsschaltung 18 verwirklichten Spannungsteiler fällt an den beiden Widerständen 26 und 28, die beide eine elektrische Widerstandsgröße R aufweisen, jeweils eine Spannung von 2,5 Volt ab, so dass das Spannungsmessgerät 32 eine Spannung von 2,5 Volt mißt. Diese Spannung dient als Referenzspannung.

Figur 3b zeigt die Detektionsvorrichtung 2 für den Fall einer fehlerhaften Masseverbindung 9 und einer fehlerfreien Masseverbindung 13. Die fehlerhafte Masseverbindung 9 bedingt einen Übergangswiderstand R₁, an dem eine Spannung von 1 Volt abfällt. Die fehlerfreie Masseverbindung 13 bedingt wie in Figur 3a einen verschwindenden Übergangswiderstand R₂, weshalb an der Masseverbindung 13 der Spannungsabfall 0 Volt beträgt. Sowohl an dem Widerstand 26 als auch an dem Widerstand 28 des Spannungsteilers der Detektionsschaltung 18 fallen 2 Volt ab, weshalb das Spannungsmeßgerät 32 die Summe der Spannungsabfälle an dem Widerstand 28 und an der Masseverbindung 9, also eine Detektionsspannung von 3 Volt, anzeigt.

In Figur 3c ist die Ermittlung der Detektionsspannung für den Fall dargestellt, dass die Masseverbindung 9 fehlerfrei und die Masseverbindung 13 fehlerhaft ist. In diesem Fall bedingt die Masseverbindung 9 einen verschwindenden Übergangswiderstand R₁ und einen damit verbundenen Spannungsabfall von 0 Volt, wohingegen die Masseverbindung 13 einen nicht verschwindenden Übergangswiderstand R₂ aufweist, an dem eine Spannung von 1 Volt abfällt. An dem Widerstand 26 fallen 2,5 Volt und an dem Widerstand 28 fallen 2,5 Volt ab. Da das Spannungsmeßgerät 32 die an dem Widerstand 28 abfallenden 3 Volt nicht gegen die Masse 5, sondern gegen den Spannungsabfall von 1 Volt an der Masseverbindung 13 mißt, zeigt es eine der Differenz der beiden Spannungen entsprechende Detektionsspannung von 1,5 Volt an.

Die Figuren 3a, 3b und 3c machen hinsichtlich der Funktionsweise der Detektionsschaltung 18 folgendes deutlich: Die in der Schaltung gemäß Figur 3a an dem Spannungsmeßgerät 32 detektierte Spannung von 2,5 Volt ist die Referenzspannung, da in diesem Fall beide Masseverbindungen 9 und 13 fehlerfrei sind. Die in der Schaltung von Figur 3b detektierte Spannung von 3 Volt ist die Detektionsspannung für den Fall einer fehlerhaften Masseverbindung 9, wohingegen die in der Schaltung gemäß Figur 3c gemessene Spannung von 1,5 Volt die Fehlerhaftigkeit der Masseverbindung 13 anzeigt. Detektionsspannungen, die die Referenzspannung von 2,5 Volt übersteigen, detektieren mithin eine Fehlerhaftigkeit der Masseverbindung 9, wohingegen bei einem Unterschreiten der Referenzspannung eine Fehlerhaftigkeit der Masseverbindung 13 vorliegt. Eine Lokalisierung der fehlerhaften Masseverbindung ist mithin einfach möglich.

Die eben beschriebene Ausführungsform zeigt eine elektrische Einrichtung mit zwei Teilsystemen. Es sind selbstverständlich auch mehr als zwei Teilsysteme beziehungsweise nur ein einziges elektrisches Teilsystem einsetzbar. In diesem letzten Fall wäre die Referenzspannung bei einer fehlerfreien Masseverbindung 0 Volt. Jede Detektionsspannung (die in diesem Fall direkt dem Spannungsabfall an der Masseverbindung entspricht), deren Betrag größer Null ist, würde auf die Fehlerhaftigkeit der Masseverbindung hindeuten. Rein beispielhaft wurde vorstehend die Funktion anhand einer Spannungsmessung erläutert, selbstverständlich kann auch über eine Strommessung eine fehlerhafte Masseverbindung ermittelt werden.

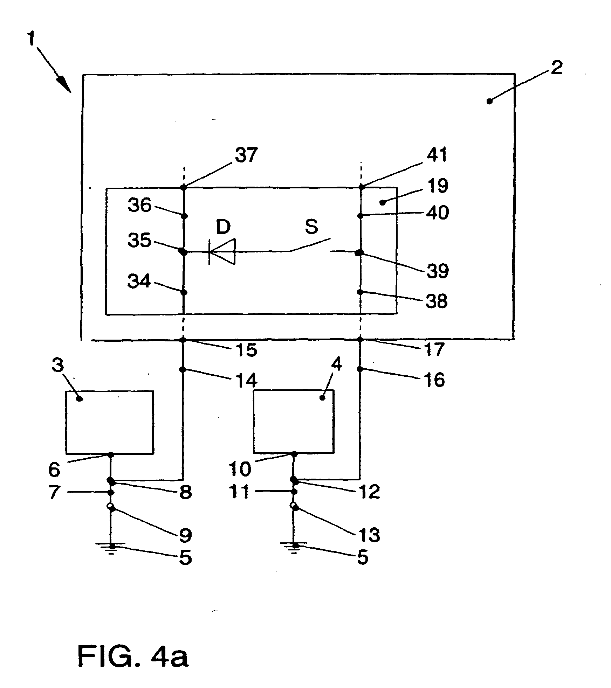

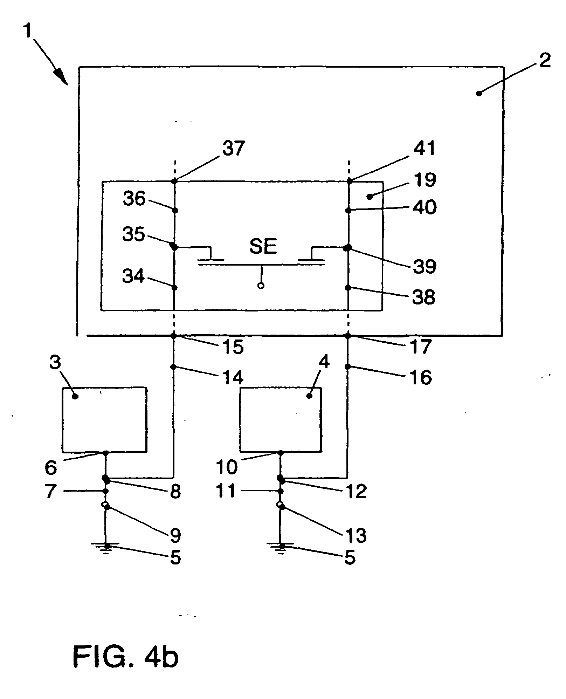

Die Figuren 4a und 4b zeigen zwei Ausführungsformen der Überbrückungsschaltung 19, die in die Detektionsvorrichtung 2 der elektrischen Einrichtung 1 eingebaut sind. In beiden Figuren ist der Punkt 15 über eine elektrische Verbindung 34 mit einem Verzweigungspunkt 35 elektrisch verbunden. Der Verzweigungspunkt 35 ist über eine elektrische Verbindung 36 mit einem Punkt 37 verbunden, an den beispielsweise die Detektionsschaltung 18 angeschlossen sein kann. Den elektrischen Verbindungen 34 und 36, dem Verzweigungspunkt 35 und dem Punkt 37 des ersten Teilsystems 3 entsprechen bei dem zweiten Teilsystem 4 die elektrischen Verbindungen 38 und 40, der Verzweigungspunkt 39 und der Punkt 41.

Die Überbrückungsschaltung 19 ist in der Ausführungsform gemäß Figur 4a als Reihenschaltung einer Diode D und eines Schalters S realisiert, die sich zwischen den Verzweigungspunkten 35 und 39 befinden.

Figur 4b zeigt hingegen in der Überbrückungsschaltung 19 ein Schaltelement SE, insbesondere Halbleiter-Schaltelement, das als bipolarer Transistor, unipolarer Transistor oder dergleichen realisiert sein kann. In beiden Fällen bewirken die zwischen den Verzweigungspunkten 35 und 39 befindlichen elektronischen Bauelemente eine leitende Verbindung zwischen den Masseverbindungen 9 und 13, das heißt eine Parallelschaltung oder ein gänzliches Umschalten von der einen auf die andere Masseverbindung.

## Patentansprüche

1. Verfahren zur Detektion einer fehlerhaften Masseverbindung in einer elektrischen Einrichtung, insbesondere eines Kraftfahrzeugs, die über wenigstens zwei Masseverbindungen (9, 13) mit einer Masse (5) verbunden ist, mit den Verfahrensschritten:
- Ermitteln eines Messwerts eines Detektionsparameters mittels einer mit den wenigstens zwei Masseverbindungen (9,13) verbundenen Detektionsschaltung (18);
- Vergleichen des ermittelten Messwerts mit einem festlegbaren Referenzwert;
- Feststellen wenigstens einer fehlerhaften Masseverbindung bei einer Abweichung zwischen dem Messwert und dem Referenzwert;
- Erzeugen einer Fehlermeldung bei festgestellter fehlerhafter Masseverbindung,
**dadurch gekennzeichnet, dass**, bei einer Fehlermeldung, eine fehlerhafte Masseverbindung (9, 13) und eine fehlerfreie Masseverbindung (13, 9) durch eine Überbrückungsschaltung (19), die zwischen der fehlerhaften Masseverbindung (9, 13) und der fehlerfreien Masseverbindung (13, 9) zum wahtweisen elektrischen Verbinden der Masseverbindungen vorgesehen ist und die bei Nicht-Vorliegen einer Fehlermeldung geöffnetes Schaltmittel (S, SE) enthält, durch Schließen des Schaltmittels der Überbrückungsschaltung (19) parallel geschaltet werden.

2. Verfahren nach Anspruch 1, **dadurch gekennzeichnet, dass** bei einer Fehlermeldung über eine mit den Masseverbindungen (9,13) verbundene Meldeschaltung (21) ein Fehlersignal ausgegeben wird.

3. Verfahren nach einem der vorhergehenden Ansprüche, **dadurch gekennzeichnet, dass** die Fehlermeldung über eine mit den Masseverbindungen (9,13) verbundene Meldeschaltung (21) in einem Speichermittel der elektrischen Einrichtung (1) hinterlegt wird.

4. Verfahren nach einem der vorhergehenden Ansprüche, **dadurch gekennzeichnet, dass** die Detektionsschaltung (18) mittels einer mit ihr verbundenen Kontrollschaltung (23) punktuell zu vorgebbaren Zeitpunkten oder kontinuiertich in vorgebbaren Zeitintervallen oder permanent kontrolliert wird.

5. Verfahren nach einem der vorhergehenden Ansprüche, **dadurch gekennzeichnet, dass** der Detektionsparameter und der Parameter des Referenzwerts elektrische Spannungswerte sind.

## Claims

1. Method for detecting a faulty earth connection in an electrical device, in particular of a motor vehicle, which is connected to earth (5) via at least two earth connections (9, 13), having the method steps of:
- acquiring a measured value of a detection parameter by means of a detection circuit (18) which is connected to the at least two earth connections (9, 13);
- comparing the acquired measured value with a prescribable reference value;
- determining at least one faulty earth connection when the measured value and the reference value differ;
- producing a fault report when a faulty earth connection has been determined,
**characterized in that**, when a fault is reported, a faulty earth connection (9, 13) and a fault-free earth connection (13, 9) are connected in parallel by closing the switching means of a bridging circuit (19) which is provided between the faulty earth connection (9, 13) and the fault-free earth connection (13, 9) for the optional electrical connection of the earth connections and which includes open switching means (S, SE) when there is no fault report.

2. Method according to Claim 1, **characterized in that**, when a fault is reported, a fault signal is output by a signalling circuit (21) which is connected to the earth connections (9, 13).

3. Method according to either of the preceding claims, **characterized in that** the fault report is stored in a memory means in the electrical device (1) by a signalling circuit (21) which is connected to the earth connections (9, 13).

4. Method according to one of the preceding claims, **characterized in that** the detection circuit (18) is controlled by means of a control circuit (23) which is connected to it at certain points at predefinable points in time or continuously at predefinable time intervals or continuously.

5. Method according to one of the preceding claims, **characterized in that** the detection parameter and the parameter of the reference value are electrical voltage values.

## Revendications

1. Procédé de détection d'une liaison de masse défaillante dans un équipement électrique, notamment un véhicule automobile, qui est relié à une masse (5) par le biais d'au moins deux liaisons de masse (9, 13), comprenant les étapes suivantes :
- Détermination d'une valeur mesurée d'un paramètre de détection au moyen d'un circuit de détection (18) relié avec les au moins deux liaisons de masse (9, 13) ;
- Comparaison de la valeur mesurée déterminée avec une valeur de référence pouvant être définie ;
- Détermination d'au moins une liaison de masse défaillante en présence d'un écart entre la valeur mesurée et la valeur de référence ;
- Production d'un message d'erreur en cas de constatation d'une liaison de masse défaillante,
**caractérisé en ce qu'**en cas de message d'erreur, une liaison de masse défaillante (9, 13) et une liaison de masse sans défaut (13, 9) sont branchées en parallèle par un circuit de court-circuit (19), lequel est prévu entre la liaison de masse défaillante (9, 13) et la liaison de masse sans défaut (13, 9) pour réaliser la connexion électrique au choix des liaisons de masse et qui contient un moyen de commutation (S, SE) ouvert en l'absence de message d'erreur, en fermant le moyen de commutation du circuit de court-circuit (19).

2. Procédé selon la revendication 1, **caractérisé en ce qu'**en cas de message d'erreur, un signal de défaut est délivré par le biais d'un circuit de signalisation (21) relié aux liaisons de masse (9, 13).

3. Procédé selon l'une des revendications précédentes, **caractérisé en ce que** le message d'erreur est stocké dans un moyen de mémorisation de l'équipement électrique (1) par le biais d'un circuit de signalisation (21) relié avec les liaison de masse (9, 13).

4. Procédé selon l'une des revendications précédentes, **caractérisé en ce que** le circuit de détection (18) est contrôlé ponctuellement à des moments pouvant être prédéfinis ou continuellement à des intervalles de temps pouvant être prédéfinis ou en permanence au moyen d'un circuit de contrôle (23) qui y est relié.

5. Procédé selon l'une des revendications précédentes, **caractérisé en ce que** les paramètres de détection et les paramètres de la valeur de référence sont des valeurs de tension électrique.
